# EUROPEAN PATENT APPLICATION

(11) **EP 4 848 949 A1**
(43) Date of publication of application: **02.12.2026**
(21) Application number: 25186968.1
(22) Date of filing: 02.07.2025
(51) Int. Cl.: H10F 71/00

(54) **BACK-CONTACT SOLAR CELL, METHOD FOR PREPARING THE SAME AND PHOTOVOLTAIC MODULE**

(30) Priority: 29.05.2025 CN 202510716006
(71) Applicant: Zhejiang Jinko Solar Co., Ltd., Haining, Zhejiang 314416 (CN)
(72) Inventor: LI, Huimin, Haining, Zhejiang 314416 (CN); XU, Menglei, Haining, Zhejiang 314416 (CN); YANG, Jie, Haining, Zhejiang 314416 (CN); ZHANG, Xinyu, Haining, Zhejiang 314416 (CN)
(74) Representative: Herrero & Asociados, S.L.

(57) **Abstract**

The present application relates to a back-contact solar cell, a method for preparing the same, and a photovoltaic module. The method for preparing a back-contact solar cell includes providing a pre-processed solar cell, wherein positive electrode grid lines and negative electrode grid lines are arranged at intervals on a first surface of the pre-processed solar cell; applying a reverse voltage lower than a breakdown voltage to the pre-processed solar cell in a first preset region; performing scanning irradiation on the pre-processed solar cell in a second preset region using a laser light source, and controlling a circuit current value in the second preset region to be in a range from 0.1 A to 40 A; wherein the first preset region and the second preset region are different regions of the pre-processed solar cell.

## Description

### TECHNICAL FIELD

The present application relates to the field of photovoltaic technology, and in particular to a back-contact solar cell, a method for preparing the same, and a photovoltaic module.

### BACKGROUND

Silicon-based solar cells are currently the most widely used type of solar cell. In silicon-based solar cells, P-type silicon and N-type silicon are formed through doping. PN junction is formed at the junction between them, creating a built-in electric field. Under the action of the built-in electric field, photogenerated carriers separate, with electrons moving towards the N-region and holes moving towards the P-region. When an external circuit is closed, the separated electrons and holes flow through the circuit, forming an electric current, thereby converting solar energy into electrical energy. In the back-contact solar cells, positive and negative electrode grid lines are all concentrated on the back side of the cell, avoiding light shading losses by front grid lines, and enabling higher photoelectric conversion efficiency.

### SUMMARY

Based on this, it is necessary to provide a back-contact solar cell, a method for preparing the same, and a photovoltaic module. The method for preparing the back-contact solar cell of the present application can improve the passivation contact performance of the back-contact solar cell, increase the open circuit voltage and fill factor of the back-contact solar cell, and thus improve the conversion efficiency.

In a first aspect, the present application provides a method for preparing a back-contact solar cell, including:
providing a pre-processed solar cell, wherein positive electrode grid lines and negative electrode grid lines are arranged at intervals on a first surface of the pre-processed solar cell;
applying a reverse voltage lower than a breakdown voltage to the pre-processed solar cell in a first preset region;
performing scanning irradiation on the pre-processed solar cell in a second preset region using a laser light source, and controlling a circuit current value in the second preset region to be in a range from 0.1 A to 40 A; wherein the first preset region and the second preset region are different regions of the pre-processed solar cell.

In some embodiments, the scanning irradiation includes a first scanning period, a second scanning period and a third scanning period in sequence;
during the first scanning period, the circuit current value in the second preset region is controlled to increase, and a voltage value in the second preset region is controlled to decrease;
during the third scanning period, the circuit current value in the second preset region is controlled to decrease, and a voltage value in the second preset region is controlled to increase; and
during the second scanning period, the circuit current value in the second preset region is controlled to maintain a fluctuation amplitude smaller than or equal to a first preset value.

In some embodiments, the second scanning period includes a first sub-scanning period, a second sub-scanning period and a third sub-scanning period in sequence;
a voltage value of the first sub-scanning period is controlled to be greater than a voltage value of the second sub-scanning period; and
a voltage value of the first sub-scanning period is controlled to be greater than a voltage value of the third sub-scanning period.

In some embodiments, during the second sub-scanning period, a voltage value in an initial stage in the second preset region is controlled to be greater than a voltage value in a final stage in the second preset region.

In some embodiments, during the second sub-scanning period, the voltage value in the second preset region is controlled to maintain a fluctuation amplitude smaller than or equal to a second preset value.

In some embodiments, during the second sub-scanning period, the voltage value in the second preset region is controlled to have a larger fluctuation amplitude in the initial stage.

In some embodiments, during the second sub-scanning period, the voltage value in the second preset region is controlled to have a smaller fluctuation amplitude in the final stage.

In some embodiments, the first preset value is [-2 A, + 2 A].

In some embodiments, the second preset value is [-1 V, + 4 V].

In some embodiments, the voltage value of the third sub-scanning period is controlled to be greater than the voltage value in a final stage of the second sub-scanning period.

In some embodiments, the voltage value of the third sub-scanning period is controlled to be less than the voltage value in an initial stage of the second sub-scanning period.

In some embodiments, during the first sub-scanning period, a fluctuation amplitude of the voltage value in the second preset region is controlled to be smaller than or equal to a third preset value.

In some embodiments, during the third sub-scanning period, a fluctuation amplitude of the voltage value in the second preset region is controlled to be smaller than or equal to the third preset value.

In some embodiments, the third preset value is [-0.5 V, + 0.5 V].

In some embodiments, a duration of the second sub-scanning period, a duration of the first sub-scanning period, and a duration of the third sub-scanning period decrease in sequence.

In some embodiments, after applying the reverse voltage lower than the breakdown voltage to the pre-processed solar cell in the first preset region and before performing scanning irradiation on the pre-processed solar cell in the second preset region using the laser light source, the circuit current value in the second preset region is less than 10 A.

In some embodiments, the first preset region and the second preset region are portions of the first surface.

In some embodiments, the first preset region is a portion of the first surface, the second preset region is a portion of a second surface, and the second surface is opposite to the first surface.

In some embodiments, the laser light source is controlled to have a circular or rectangular light spot shape.

In some embodiments, a wavelength of the laser light source is in a range from 300 nm to 1200 nm

In some embodiments, a scanning speed of the laser light source is controlled to be in a range from 0.5 m/s to 8 m/s.

In some embodiments, a scanning time of the laser light source is controlled to be in a range from 0.05 s to 30 s.

In some embodiments, an equivalent load of a detection circuit for the pre-processed solar cell is less than 5 Ω.

In some embodiments, the reverse voltage is in a range from 1 V to 25 V.

In some embodiments, during the scanning irradiation, a surface temperature of the pre-processed solar cell is controlled to be less than 300°C.

In a second aspect, the present application provides a back-contact solar cell prepared by the method for preparing the back-contact solar cell in any embodiment as described above.

In some embodiments, an emitter square resistance of the solar cell is less than 1000 Ω/sq.

In a third aspect, the present application provides a photovoltaic module, including:
a cover plate;
at least one cell string, including a plurality of back-contact solar cells as described above, and
an encapsulation layer disposed between the cover plate and the cell string, the cover plate being connected to the cell string through the encapsulation layer.

In the method for preparing the back-contact solar cell as described above, the reverse voltage lower than the breakdown voltage is applied to the pre-processed solar cell in the first preset region, scanning irradiation is perforemd on the pre-processed solar cell in the second preset region that is different from the first preset region using a laser light source. By performing the scanning irradiation on the pre-processed solar cell using the laser light source, charge carriers are excited; and meanwhile by applying the reverse voltage, a local electric current can be generated in the second preset region. Under the action of the electric current, the sintering performed at the irradiation point of the laser light source causes the grid line paste to diffuse into the silicon material, thereby significantly reducing the contact resistance between the metal and the semiconductor. After the diffusion contact, the resistance is reduced, the heat at the melting point disappears instantly, and the temperature is reduced, thereby forming an ohmic contact with better contact effect and higher contact quality. On the basis of applying the reverse voltage lower than the breakdown voltage to the pre-processed solar cell in the first preset region, performing scanning irradiation on the pre-processed solar cell in the second preset region using the laser light source, and controlling the circuit current value in the second preset region to be in a range from 0.1 A to 40 A, the reverse voltage and the laser source are applied in combination. Simultaneously, during the first scanning period, the circuit current value in the second preset region is controlled to increase, and the voltage value in the second preset region is controlled to decrease; during the second scanning period, the fluctuation amplitude of the circuit current value in the second preset region is controlled to be smaller than or equal to the first preset value; and during the third scanning period, the circuit current value in the second preset region is controlled to decrease, and the voltage value in the second preset region is controlled to increase, which improves the synchronization matching between the laser and the voltage, ensurs that carriers excited by laser directionally move under the action of the electric field, reduces a decrease in current density caused by carrier recombination, and improves sintering quality, thereby facilitating the improvement of the passivation contact performance of the back-contact solar cell, and the increase of the open circuit voltage and fill factor of the back-contact solar cell, and thus improving the conversion efficiency.

### BRIEF DESCRIPTION OF THE DRAWINGS

FIG. 1 is a step schematic view of a method for preparing a back-contact solar cell in an embodiment of the present application.
FIG. 2 is a schematic view of applying a reverse voltage lower than a breakdown voltage to the pre-processed solar cell in a first preset region in an embodiment of the present application.
FIG. 3 is a curve graph of circuit current value and voltage value in a second preset region during performing scanning irradiation on the pre-processed solar cell in the second preset region using a laser light source in an embodiment of the present application.

### DETAILED DESCRIPTION

In order to make the above purposes, features, and advantages of the present application more apparent and understandable, a detailed description of the specific embodiments of the present application will be given below in conjunction with the accompanying drawings. Many specific details are set forth in the following description to facilitate a full understanding of the present application. However, the present application can be implemented in many ways different from the embodiments described herein, and those skilled in the art can make similar improvements without departing from the content of the present application. Therefore, the present application is not limited by the specific embodiments disclosed below.

Unless otherwise defined, all technical and scientific terms used herein have the same meaning as commonly understood by persons skilled in the art to which the present invention belongs. The terms used in the Specification of the present application are for the purpose of describing the specific embodiments only, and are not intended to limit the present application. The term "and/or" used herein includes any and all combinations of one or more of the associated listed items.

In the description of the present application, it should be understood that the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present application and simplifying the description, rather than indicating or implying that the related devices or element must have the specific orientations, or be constructed or operated in the specific orientations, and therefore cannot be understood as limitations of the present application.

In addition, terms such as "first", "second" are merely used for describing purposes and cannot be understood as indicating or implying relative importance, or implicitly indicating the number of indicated technical features. In view of that, the features defined with "first", "second" can explicitly or implicitly include at least one of the features. In the present application, the term "a plurality of" means at least two, including two, three, etc., unless otherwise explicitly and specifically defined.

In the present application, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element or connected to the other element via an intermediate medium, or may be the internal connection of two elements or the interaction relationship between them. For those skilled in the art, the specific meanings of the above terms in the present application can be understood according to specific circumstances.

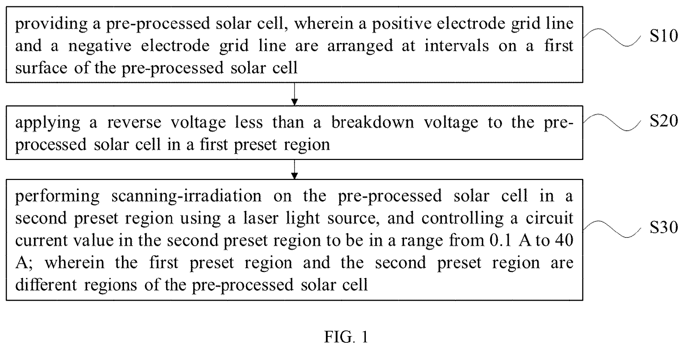

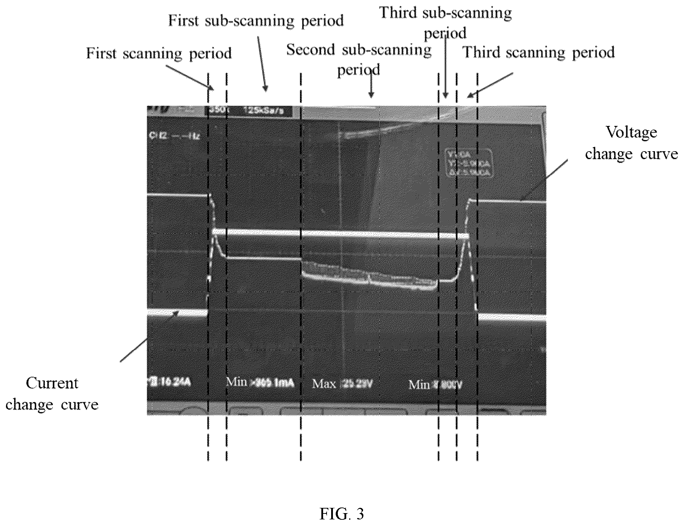

Referring to FIGS. 1 and 3, an embodiment of the present application provides a method for preparing a back-contact solar cell, including:
providing a pre-processed solar cell, wherein positive electrode grid lines and negative electrode grid lines are arranged at intervals on a first surface of the pre-processed solar cell;
applying a reverse voltage lower than a breakdown voltage to the pre-processed solar cell in a first preset region;
performing scanning irradiation on the pre-processed solar cell in a second preset region using a laser light source, and controlling a circuit current value in the second preset region to be in a range from 0.1 A to 40 A; wherein the first preset region and the second preset region are different regions of the pre-processed solar cell.

In some embodiments, the scanning irradiation includes a first scanning period, a second scanning period and a third scanning period in sequence;
during the first scanning period, the circuit current value in the second preset region is controlled to increase, and a voltage value in the second preset region is controlled to decrease;
during the third scanning period, the circuit current value in the second preset region is controlled to decrease, and a voltage value in the second preset region is controlled to increase; and
during the second scanning period, the circuit current value in the second preset region is controlled to maintain a fluctuation amplitude smaller than or equal to a first preset value.

It can be understood that before performing scanning irradiation on the pre-processed solar cell in the second preset region using the laser light source, the positive electrode grid lines and the negative electrode grid lines arranged at intervals on the first surface of the pre-processed solar cell are all grid line pastes. Through the above-mentioned preparation method, good ohmic contact between the positive and negative grid lines and the doped silicon layer in the pre-processed solar cell can be achieved. In the method for preparing the back-contact solar cell as described above, the reverse voltage lower than the breakdown voltage is applied to the pre-processed solar cell in the first preset region, scanning irradiation is perforemd on the pre-processed solar cell in the second preset region that is different from the first preset region using a laser light source. By performing the scanning irradiation on the pre-processed solar cell using the laser light source, charge carriers are excited; and meanwhile by applying the reverse voltage, a local electric current can be generated in the second preset region. Under the action of the electric current, the sintering performed at the irradiation point of the laser light source causes the grid line paste to diffuse into the silicon material, thereby significantly reducing the contact resistance between the metal and the semiconductor. After the diffusion contact, the resistance is reduced, the heat at the melting point disappears instantly, and the temperature is reduced, thereby forming an ohmic contact with better contact effect and higher contact quality. On the basis of applying the reverse voltage lower than the breakdown voltage to the pre-processed solar cell in the first preset region, performing scanning irradiation on the pre-processed solar cell in the second preset region using the laser light source, and controlling the circuit current value in the second preset region to be in a range from 0.1 A to 40 A, the reverse voltage and the laser source are applied in combination. Simultaneously, during the first scanning period, the circuit current value in the second preset region is controlled to increase, and the voltage value in the second preset region is controlled to decrease; during the second scanning period, the fluctuation amplitude of the circuit current value in the second preset region is controlled to be smaller than or equal to the first preset value; and during the third scanning period, the circuit current value in the second preset region is controlled to decrease, and the voltage value in the second preset region is controlled to increase, which improves the synchronization matching between the laser and the voltage, ensurs that carriers excited by laser directionally move under the action of the electric field, reduces a decrease in current density caused by carrier recombination, and improves sintering quality, thereby facilitating the improvement of the passivation contact performance of the back-contact solar cell, and the increase of the open circuit voltage and fill factor of the back-contact solar cell, and thus improving the conversion efficiency.

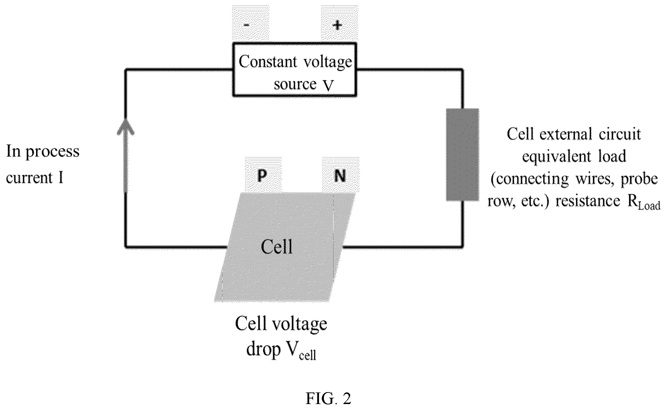

Referring to FIG. 2, it can be understood that the circuit current in the second preset region refers to the current value of the output signal of the back-contact solar cell, and the voltage value refers to the voltage value of the output signal of the back contact solar cell. The changes of the circuit current and the voltage value can be monitored by setting a voltage and current detection module at both ends of the solar cell sheet. Exemplarily, the reverse voltage can be applied by connecting an external voltage source to the grid line of the back contact solar cell. The contact point between the voltage source and the solar cell can be a welding point or a grid line. The contact point can be all grid lines and all welding points in the first preset region, or a part of the grid lines and a part of the welding points in the first preset region. It is understood that compared with the prior art in which the positive grid line and the negative grid line are disposed on different sides of the cell, the positive grid line and the negative grid line in the back contact solar cell are both disposed on the same surface of the solar cell. When the reverse voltage is applied to the pre-processed solar cell in the first preset region, the process is relatively difficult and needs to be accurately controlled. Exemplarily, the contact between the voltage source and the solar cell can be achieved by a probe.

By controlling the circuit current value in the second preset region, the local heat generation efficiency in the second preset region can be controlled. Within the range of the above circuit current value, it is conducive to melting the grid line paste and achieve co-diffusion between the grid line paste and silicon based on the instantaneous temperature in the second preset region, and forming a highly conductive ohmic contact region after cooling, while also avoiding the risk of thermal damage to the pre-processed solar cell. Optionally, the circuit current value in the second preset region is controlled to be 0.1 A, 0.2 A, 0.5 A, 1 A, 2 A, 5 A, 8 A, 10 A, 15 A, 20 A, 25 A, 30 A, 35 A, or 40 A. Alternatively, the circuit current value in the second preset region can be controlled to be within the range between any two of the above circuit current values. Preferably, the circuit current value in the second preset region is controlled to be in a range from 2 A to 20 A.

In some embodiments, the voltage value in the second preset region is different from the reverse voltage value.

In some embodiments, the first preset value is [-2 A, + 2 A].

Optionally, the first preset value is -2 A, -1.5 A, -1 A, -0.5 A, 0 A, + 0.5 A, + 1 A, + 1.5 A, or + 2 A. Alternatively, the first preset value may be within the range between any two of the above current values.

In some embodiments, the second scanning period includes a first sub-scanning period, a second sub-scanning period, and a third sub-scanning period in sequence;
a voltage value of the first sub-scanning period is controlled to be greater than a voltage value of the second sub-scanning period; and
a voltage value of the first sub-scanning period is controlled to be greater than a voltage value of the third sub-scanning period.

On the basis of controlling the signals of the first scanning period, the second scanning period and the third scanning period, through driving the directional movement of the charge carriers by the reverse voltage, controlling the voltage value of the first sub-scanning period to be greater than the voltage value of the second sub-scanning period, and controlling the voltage value of the first sub-scanning period to be greater than the voltage value of the third sub-scanning period, the reverse voltage and scanning irradiation energy of the laser light source can produce a synergistic effect, promoting the electric field to accelerate electron migration, causing collisions with the grid line paste to generate Joule heat, and promoting the formation of the ohmic contact region, thereby facilitating the improvement of the passivation contact performance of the back-contact solar cell, and the increase of the open circuit voltage and fill factor of the back-contact solar cell, and thus improving the conversion efficiency.

In some embodiments, during the second sub-scanning period, a voltage value in an initial stage in the second preset region is controlled to be greater than a voltage value in a final stage in the second preset region.

It can be understood that, in the second sub-scanning period, the initial stage refers to a first-half time period close to the first sub-scanning period, and the final stage refers to a second-half time period close to the third sub-scanning period. During the second sub-scanning period, controlling the voltage value in the initial stage in the second preset region to be greater than the voltage value in the final stage means that, in the second preset region, the voltage value in a first-half time period of the second sub-scanning period is greater than the voltage value of a second-half time period of the second sub-scanning period. Controlling the voltage value in the initial stage in the second preset region to be greater than the voltage value in the final stage during the second sub-scanning period facilitates the improvement of the passivation contact performance of the back-contact solar cell, and the increase of the open circuit voltage and fill factor of the back-contact solar cell, and thus improving the conversion efficiency.

In some embodiments, during the second sub-scanning period, a fluctuation amplitude of the voltage value in the second preset region is controlled to be smaller than or equal to a second preset value.

In some embodiments, the second preset value is [-1 V, + 4 V].

Optionally, the second preset value is -1 V, -0.5 V, 0 V, + 0.5 V, + 1 V, + 1.5 V, + 2 V, + 2.5 V, + 3 V, + 3.5 V, or + 4 V. Optionally, the second preset value may be within the range between any two of the above voltage values.

It can be understood that, in the above-mentioned method for preparing the solar cell, controlling the fluctuation amplitude of the voltage value has significant effects, as follows: (1) Effects on contact resistance: Appropriate reverse voltage can promote the mutual diffusion between the conductive particles in grid line paste and the silicon, reducing contact resistance. If the voltage fluctuation amplitude is too large, the reverse voltage may be too high or too low in an instant. When the reverse voltage is too high, it may cause the cell to have reverse breakdown. Once reverse breakdown occurs, the local conductive current density in the illuminated area will be much lower than that when there is no breakdown due to the current shunting effect, resulting in increased contact resistance between metal and silicon. If the reverse voltage is too low, it cannot provide sufficient driving force, resulting in insufficient carrier movement and insufficient silver-silicon mutual diffusion, also resulting in increased contact resistance. (2) Effects on cell efficiency: When the voltage fluctuation amplitude is too large, it is easy to cause deviation from the optimal voltage value in the sintering process, which reduces the cell efficiency. When the reverse voltage is too high and exceeds the threshold, although the contact resistance may be further reduced, the passivation layer is damaged, which increases the recombination current density, reduces the open circuit voltage, reduces the overall performance, and significantly reduces the efficiency. When the reverse voltage is too low, the carrier concentration is insufficient, the contact optimization effect is poor, the fill factor is reduced, and the cell efficiency is also reduced. (3) Impact on the passivation layer: A stable and appropriate voltage value helps to reduce damage to the passivation layer. If the fluctuation amplitude of the voltage value is too large, the excessively high voltage will cause the passivation layer to be subjected to excessive electric field and energy, resulting in increased damage to the passivation layer, affecting its passivation effect on the cell and increasing the recombination of carriers inside the cell; whereas too low voltage value makes it difficult to fully utilize the synergistic effect of the laser and the reverse voltage to optimize the contact, and it may be necessary to increase the sintering temperature to compensate the contact, which will also cause certain damage to the passivation layer.

Controlling the fluctuation amplitude of the voltage value in the second preset region to be smaller than or equal to the second preset value facilitates the controlling of the voltage value within a preferred voltage value range during the scanning irradiation, so as to reduce the contact resistance while reducing the impact on the cell efficiency and the passivation layer, thereby improving the passivation contact performance of the back-contact solar cell, increasing the open circuit voltage and fill factor of the back-contact solar cell, and thus improving the conversion efficiency.

In some embodiments, during the second sub-scanning period, in the second preset region, the fluctuation amplitude of the voltage value is controlled to be larger in the initial stage.

In some embodiments, during the second sub-scanning period, in the second preset region, the fluctuation amplitude of the voltage value is controlled to be smaller in the final stage.

In some embodiments, the voltage value of the third sub-scanning period is controlled to be greater than the voltage value in the final stage of the second sub-scanning period.

It can be understood that, in the second sub-scanning period, the initial stage refers to a first-half time period close to the second sub-scanning period, and the final stage refers to a second-half time period close to the third scanning period. The voltage value of the third sub-scanning period is greater than the voltage value in the final stage of the second sub-scanning period, which means that the voltage value in a first-half time period of the third sub-scanning period is greater than the voltage value of the second-half time period of the second sub-scanning period. Controlling the voltage value of the third sub-scanning period to be greater than the voltage value in the final stage of the second sub-scanning period facilitates the improvement of the passivation contact performance of the back-contact solar cell, and the increase of the open circuit voltage and fill factor of the back-contact solar cell, and thus improving the conversion efficiency.

In some embodiments, the voltage value of the third sub-scanning period is controlled to be less than the voltage value in the initial stage of the second sub-scanning period.

Controlling the voltage value of the third sub-scanning period to be less than the voltage value in the initial stage of the second sub-scanning period facilitates the improvement of the passivation contact performance of the back-contact solar cell, and the increase of the open circuit voltage and fill factor of the back-contact solar cell, and thus improving the conversion efficiency.

In some embodiments, during the first sub-scanning period, a fluctuation amplitude of the voltage value in the second preset region is controlled to be smaller than or equal to a third preset value.

In some embodiments, during the third sub-scanning period, a fluctuation amplitude of the voltage value in the second preset region is controlled to be smaller than or equal to the third preset value.

In some embodiments, the third preset value is [-0.5 V, + 0.5 V].

Optionally, the third preset value is -0.5 V, -0.4 V, -0.3 V, -0.2 V, -0.1 V, 0 V, + 0.1 V, + 0.2 V, + 0.3 V, + 0.4 V, or + 0.5 V Alternatively, the third preset value may be within the range between any two of the above voltage values.

During the first sub-scanning period, the fluctuation amplitude of the voltage value in the second preset region is controlled to be smaller than or equal to the third preset value; and during the third sub-scanning period, the fluctuation amplitude of the voltage value in the second preset region is controlled to be smaller than or equal to the third preset value, which facilitates the controlling of the voltage value within a preferred voltage value range during the scanning irradiation, so as to reduce the contact resistance while reducing the impact on the cell efficiency and the passivation layer, thereby improving the passivation contact performance of the back-contact solar cell, increasing the open circuit voltage and fill factor of the back-contact solar cell, and thus improving the conversion efficiency.

In some embodiments, a duration of the second sub-scanning period, a duration of the first sub-scanning period, and a duration of the third sub-scanning period decrease in sequence.

Referring to FIG. 3 again, it can be seen that, in some embodiments, the scanning irradiation includes a first scanning period, a first sub-scanning period, a second sub-scanning period, a third sub-scanning period, and a third scanning period in sequence. In the first scanning period, the laser light source begins to irradiate the pre-processed solar cell, the circuit current increases rapidly, and the voltage across the cell sheet drops rapidly due to the influence of the external circuit resistance. In the first sub-scanning period, the voltage value and the current value across the pre-processed cell sheet are relatively stable, with only a small fluctuation. In the second sub-scanning period, as the scanning irradiation proceeds, the voltage value drops by 1 V to 4 V with a large fluctuation, and the circuit current remains basically unchanged. In the third sub-scanning period, near the final stage of the scanning irradiation, the voltage value stabilizes again. In the third scanning period, the laser light source leaves the pre-processed solar cell, the irradiation by laser ends, the circuit current drops rapidly, and the voltage value across the pre-processed solar cell returns to the state before the irradiation.

In some embodiments, after applying the reverse voltage lower than the breakdown voltage to the pre-processed solar cell in the first preset region and before performing scanning irradiation on the pre-processed solar cell in the second preset region using the laser light source, the circuit current value in the second preset region is less than 10 A.

Optionally, before performing scanning irradiation on the pre-processed solar cell in the second preset region using the laser light source, the circuit current value in the second preset region is greater than or equal to 0.0001 A and less than 10 A. Further optionally, before performing scanning irradiation on the pre-processed solar cell in the second preset region using the laser light source, the circuit current value in the second preset region is 0.0001 A, 0.001 A, 0.01 A, 0.1 A, 1A, 2A, 3A, 4A, 5A, 6A, 7A, 8A, 9A, 9.9 A, 9.99 A, or 9.999 A. Alternatively, before performing scanning irradiation on the pre-processed solar cell in the second preset region using the laser light source, the circuit current value in the second preset region can be within the range between any two of the above circuit current values.

In some embodiments, the first preset region and the second preset region are portions of the first surface.

In some embodiments, the first preset region is a portion of the first surface, the second preset region is a portion of a second surface, and the second surface is opposite to the first surface.

In some embodiments, the laser light source is controlled to have a circular or rectangular light spot shape.

In some embodiments, a wavelength of the laser light source is in a range from 300 nm to 1200 nm

Optionally, the wavelength of the laser light source is 300 nm, 400 nm, 500 nm, 600 nm, 700 nm, 800 nm, 900 nm, 1000 nm, 1100 nm, or 1200 nm. Alternatively, the wavelength of the laser light source may be within the range between any two of the above wavelengths.

In some embodiments, a scanning speed of the laser light source is controlled to be in a range from 0.5 m/s to 8 m/s.

Optionally, the scanning speed of the laser light source is controlled to be 0.5 m/s, 1 m/s, 2 m/s, 3 m/s, 4 m/s, 5 m/s, 6 m/s, 7 m/s, or 8 m/s. Alternatively, the scanning speed of the laser light source can be controlled to be within the range between any two of the above speed values.

In some embodiments, a scanning time of the laser light source is controlled to be in a range from 0.05 s to 30 s.

Optionally, the scanning time of the laser light source is controlled to be 0.05 s, 0.1 s, 0.5 s, 1 s, 2 s, 5 s, 10 s, 15 s, 20 s, 25 s, or 30 s. Alternatively, the scanning time of the laser light source can be controlled to be within the range between any two of the above time values.

It can be understood that by controlling the wavelength, scanning speed and scanning time of the laser light source, the energy input density per unit area can be controlled. When the energy input density per unit area is too low, charge carriers may be not effectively excited or the silver-silicon diffusion may be not effectively achieved, which in turn leads to insufficient diffusion depth, resulting in poor passivation effect and high contact resistance. When the energy input density per unit area is too high, it will lead to the expansion of the heat-affected zone, which may cause local overheating and melting of the silicon wafer, damage the surrounding passivation layer, or destroy the cell structure. Within the above-mentioned parameter ranges of the laser light source, the grid line paste and the silicon material exhibit good co-melting effect, thereby facilitating the improvement of the passivation contact performance of the back-contact solar cell, and the increase of the open circuit voltage and fill factor of the back-contact solar cell, and thus improving the conversion efficiency.

In some embodiments, an equivalent load of a detection circuit for the pre-processed solar cell is less than 5 Ω.

Optionally, the equivalent load of the detection circuit for the pre-processed solar cell is 0.001 Ω to 4.999 Ω. Further optionally, the equivalent load of the detection circuit for the pre-processed solar cell is 0.001 Ω, 0.01 Ω, 0.1 Ω, 0.5 Ω, 1 Ω, 2 Ω, 3 Ω, 4 Ω, 4.5 Ω, 4.9 Ω, 4.99 Ω, or 4.999 Ω. Alternatively, the equivalent load of the detection circuit for the pre-processed solar cell may be within the range between any two of the above resistance values.

In some embodiments, the reverse voltage is in a range from 1 V to 25 V.

The reverse voltage is used to establish an electric field in the laser irradiation region, thereby driving the charge carriers to move in a directional manner, and enhancing the local current density. When the reverse voltage is too low, it is difficult for the local current to generate enough Joule heat. When the reverse voltage is too high, it may cause arc discharge or breakdown of the passivation layer. Optionally, the reverse voltage is 1 V, 2 V, 5 V, 8 V, 10 V, 12 V, 15 V, 18 V, 20 V, 22 V, or 25 V. Alternatively, the reverse voltage can be within the range between any two of the above voltage values.

In some embodiments, during the scanning irradiation, a surface temperature of the pre-processed solar cell is controlled to be less than 300°C.

When the surface temperature of the pre-processed solar cell is too high, it may affect the performance of the cell. The surface temperature of the pre-processed solar cell can be controlled by adjusting the reverse voltage or the parameters of the laser light source. Optionally, during the scanning irradiation, the surface temperature of the pre-processed solar cell is controlled to be 20°C to 299°C. Further optionally, the surface temperature of the pre-processed solar cell is controlled to be 20°C, 30°C, 50°C, 80°C, 100°C, 120°C, 150°C, 180°C, 200°C, 220°C, 250°C, 290°C, or 299°C. Alternatively, the surface temperature of the pre-processed solar cell can be controlled to be within the range between any two of the above temperature values.

Within the above-mentioned various parameter ranges in the method for preparing the back-contact solar cell, it facilitates the improvement of the passivation contact performance of the back-contact solar cell, and the increase of the open circuit voltage and fill factor of the back-contact solar cell, and thus improving the conversion efficiency.

In another embodiment, the present application provides a back-contact solar cell prepared by the method for preparing a back-contact solar cell in any embodiment as described above.

In some embodiments, an emitter square resistance of the solar cell is less than 1000 Ω/sq.

Optionally, the emitter square resistance of the solar cell is 1 Ω/sq to 999 Ω/sq.Further optionally, the emitter square resistance of the solar cell is 1 Ω/sq, 2 Ω/sq, 5 Ω/sq, 10 Ω/sq, 20 Ω/sq, 50 Ω/sq, 100 Ω/sq, 200 Ω/sq, 300 Ω/sq, 500 Ω/sq, 600 Ω/sq, 800 Ω/sq, 900Ω/sq, or 999Ω/sq. Alternatively, the emitter square resistance of the solar cell may be within the range between any two of the above square resistances.

In yet another embodiment, the present application provides a photovoltaic module, including:
a cover plate;
at least one cell string, including a plurality of back-contact solar cells as described above, and
an encapsulation layer disposed between the cover plate and the cell string, the cover plate being connected to the cell string through the encapsulation layer.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. Therefore, the patent protection of the present application shall be defined by the appended claims, and the description and the accompanying drawings can be used to explain contents of the claims.

## Claims

1. A method for preparing a back-contact solar cell, comprising:
providing a pre-processed solar cell, wherein positive electrode grid lines and negative electrode grid lines are arranged at intervals on a first surface of the pre-processed solar cell;
applying a reverse voltage lower than a breakdown voltage to the pre-processed solar cell in a first preset region;
performing scanning irradiation on the pre-processed solar cell in a second preset region using a laser light source, and controlling a circuit current value in the second preset region to be in a range from 0.1 A to 40 A; wherein the first preset region and the second preset region are different regions of the pre-processed solar cell.

2. The method according to claim 1, wherein the scanning irradiation comprises a first scanning period, a second scanning period and a third scanning period in sequence;
during the first scanning period, the circuit current value in the second preset region is controlled to increase, and a voltage value in the second preset region is controlled to decrease;
during the third scanning period, the circuit current value in the second preset region is controlled to decrease, and a voltage value in the second preset region is controlled to increase; and
during the second scanning period, the circuit current value in the second preset region is controlled to maintain a fluctuation amplitude smaller than or equal to a first preset value.

3. The method according to claim 2, wherein the second scanning period comprises a first sub-scanning period, a second sub-scanning period and a third sub-scanning period in sequence; wherein a voltage value of the first sub-scanning period is controlled to be greater than a voltage value of the second sub-scanning period; and
a voltage value of the first sub-scanning period is controlled to be greater than a voltage value of the third sub-scanning period.

4. The method according to claim 3, wherein during the second sub-scanning period, a voltage value in an initial stage in the second preset region is controlled to be greater than a voltage value in a final stage in the second preset region.

5. The method according to claim 3 or 4, wherein during the second sub-scanning period, the voltage value in the second preset region is controlled to maintain a fluctuation amplitude smaller than or equal to a second preset value.

6. The method according to claim 5, wherein during the second sub-scanning period, the voltage value in the second preset region is controlled to have a larger fluctuation amplitude in the initial stage; and/or
during the second sub-scanning period, the voltage value in the second preset region is controlled to have a smaller fluctuation amplitude in the final stage.

7. The method according to claim 5 or 6, wherein the first preset value is [-2 A, + 2 A]; and/or the second preset value is [-1 V, + 4 V].

8. The method according to any one of claims 3 to 7, wherein the voltage value of the third sub-scanning period is controlled to be greater than the voltage value in a final stage of the second sub-scanning period; and/or
the voltage value of the third sub-scanning period is controlled to be less than the voltage value in an initial stage of the second sub-scanning period.

9. The method according to any one of claims 3 to 8, wherein during the first sub-scanning period, a fluctuation amplitude of the voltage value in the second preset region is controlled to be smaller than or equal to a third preset value; and/or
during the third sub-scanning period, a fluctuation amplitude of the voltage value in the second preset region is controlled to be smaller than or equal to the third preset value,
optionally, the third preset value is [-0.5 V, + 0.5 V].

10. The method according to any one of claims 3 to 9, wherein a duration of the second sub-scanning period, a duration of the first sub-scanning period, and a duration of the third sub-scanning period decrease in sequence.

11. The method according to any one of claims 1 to 10, wherein after applying the reverse voltage lower than the breakdown voltage to the pre-processed solar cell in the first preset region and before performing scanning irradiation on the pre-processed solar cell in the second preset region using the laser light source, the circuit current value in the second preset region is less than 10 A.

12. The method according to any one of claims 1 to 11, wherein the first preset region and the second preset region are portions of the first surface; or
the first preset region is a portion of the first surface, the second preset region is a portion of a second surface, and the second surface is opposite to the first surface.

13. The method according to any one of claims 1 to 12, wherein the laser light source is controlled to have a circular or rectangular light spot shape; and/or
a wavelength of the laser light source is in a range from 300 nm to 1200 nm; and/or
a scanning speed of the laser light source is controlled to be in a range from 0.5 m/s to 8 m/s; and/or
a scanning time of the laser light source is controlled to be in a range from 0.05 s to 30 s; and/or
an equivalent load of a detection circuit for the pre-processed solar cell is less than 5 Ω; and/or
the reverse voltage is in a range from 1 V to 25 V; and/or
during the scanning irradiation, a surface temperature of the pre-processed solar cell is controlled to be less than 300°C.

14. A back-contact solar cell, prepared by the method for preparing the back-contact solar cell of any one of claims 1 to 13;
optionally, an emitter square resistance of the solar cell is less than 1000 Ω/sq.

15. A photovoltaic module, comprising:
a cover plate;
at least one cell string, comprising a plurality of back-contact solar cells of claim 14, and
an encapsulation layer disposed between the cover plate and the cell string, the cover plate being connected to the cell string through the encapsulation layer.
